# EUROPÄISCHE PATENTANMELDUNG

(11) **EP 4 017 236 A1**
(43) Veröffentlichungstag der Anmeldung: **22.06.2022**
(21) Anmeldenummer: 20215264.1
(22) Anmeldetag: 18.12.2020
(51) Int. Cl.: H05K 13/08, H05K 13/04

(54) **VERFAHREN UND ANLAGE ZUM HERSTELLEN VON BAUGRUPPEN MIT EINER DREIDIMENSIONAL POSITIONIERBAREN EINRICHTUNG**

(71) Anmelder: Siemens Aktiengesellschaft, 80333 München (DE)
(72) Erfinder: Blank, Rene, 12249 Berlin (DE); Borwieck, Carsten, 14052 Berlin (DE); Franke, Martin, 14089 Berlin (DE); Frühauf, Peter, 14612 Falkensee (DE); Heimann, Matthias, 14469 Potsdam (DE); Knofe, Rüdiger, 14513 Teltow (DE); Müller, Bernd, 16259 Falkenberg (DE); Nerreter, Stefan, 15754 Heidesee OT Blossin (DE); Wittreich, Ulrich, 16727 Velten (DE)

(57) **Zusammenfassung**

Es wird ein Verfahren zu Herstellung von elektronischen Baugruppen (10) mittels einer Fertigungsanlage (1) angegeben, wobei das Verfahren die folgenden Verfahrensschritte aufweist:
a) sequenzielles Beladen der Fertigungsanlage (1) mit einer Mehrzahl von elektrischen Schaltungsträgern (s),
b) Bereitstellen einer Mehrzahl von Geometrie-Datensätzen (gᵢ) zu den einzelnen Schaltungsträgern (sᵢ),
- wobei die einzelnen Geometrie-Datensätze (gᵢ) jeweils eine Vielzahl von Ortsvektoren (x,y,z) aufweisen,
- wobei jeder Ortsvektor ein laterales Koordinatenpaar (x,y) für die Position innerhalb der Schaltungsträgerebene und eine zugeordnete Höhenkoordinate (z) enthält,

c) sequenzielle Prozessierung der einzelnen Schaltungsträger (sᵢ) in einer ausgewählten Prozessvorrichtung (300), welche eine dreidimensional positionierbare Einrichtung (320) enthält,
- wobei für den jeweils zu prozessierenden Schaltungsträger (sᵢ) der ihm zugeordneten Geometrie-Datensatz (gᵢ) verwendet wird,
um zu einer vorgegebenen lateralen Zielposition (x,y) der positionierbaren Einrichtung eine zugehörige Ziel-Höhenkoordinate (z1) zu ermitteln
und die Einrichtung bei der lateralen Zielposition (x,y) in dieser Ziel-Höhenkoordinate (z1) zu positionieren.

Weiterhin wird eine Fertigungsanlage (1) zur Durchführung dieses Verfahrens angegeben.

## Beschreibung

Die vorliegende Erfindung betrifft ein Verfahren zur Herstellung von elektronischen Baugruppen, bei welchem eine Mehrzahl von elektrischen Schaltungsträgern in einer Fertigungsanlage mit ein oder mehreren Prozessvorrichtungen sequenziell prozessiert werden. Weiterhin betrifft die Erfindung eine Fertigungsanlage zur Durchführung eines solchen Verfahrens.

Aus dem Stand der Technik sind Fertigungsverfahren für elektronische Baugruppen bekannt, bei denen Leiterplatten und ähnliche elektrische Schaltungsträger mit elektronischen Bauelementen bestückt und elektrisch mit diesen verbunden werden. Im Rahmen dieser Prozessierung kommen neben dem eigentlichen Bestücken auch Druckprozesse, zum Beispiel zum Auftragen von Lot- oder Sinterpasten, sowie optische Inspektionsprozesse und thermische Schritte zum Löten oder Sintern zum Einsatz. Häufig werden die elektrischen Schaltungsträger dabei beidseitig prozessiert, so dass auf beiden Hauptflächen funktionale Bauteile angeordnet werden. Die elektronischen Baugruppen werden dabei oft in Serienfertigung hergestellt, sodass eine Vielzahl von untereinander gleichen oder ähnlichen Baugruppen in einer automatisierten Fertigungsanlage hintereinander prozessiert werden. Durch das Layout der Baugruppe sind dabei die Verläufe der einzelnen Leiterbahnen auf dem Schaltungsträger und die Positionen und Verbindungsstellen für die darauf aufgesetzten elektronischen Baugruppen definiert.

Ein Problem bei diesen bekannten Fertigungsverfahren ist, dass sich die einzelnen Schaltungsträger in ihrer exakten Geometrie in der Praxis von Stück zu Stück leicht voneinander unterscheiden. Dies trifft vor allem für Leiterplatten auf Basis von faserverstärkten Kunststoffen zu, welche abhängig von ihrer genauen Materialzusammensetzung und dem gewählten Herstellungsprozess eine mehr oder weniger starke Verwölbung aufweisen. Aber auch bei anderen Arten von Schaltungsträgern kann dieses Problem bestehen, dass sie zwar nominell planar, in der Realität aber leicht uneben sind. Vor allem beim Bestücken der elektronischen Bauelemente können sich praktische Probleme ergeben: Die typischerweise verwendeten Bestückungsvorrichtungen benötigen für jedes auf der Oberfläche des Schaltungsträgers abzusetzende Bauteil einen möglichst genauen dreidimensionalen Zielkoordinatensatz. Wenn die exakte Höhe der lokalen Schaltungsträgeroberfläche mit leichten Schwankungen verbunden ist, dann muss der Bestückungskopf zunächst in einem größeren Sicherheitsabstand von der Oberfläche positioniert werden, um dann von dieser ersten Zielposition aus eine sehr langsame und vorsichtige Annäherung an die tatsächliche Oberfläche vorzunehmen. Wenn das zu bestückende Bauteil nämlich zu schnell bzw. zu kraftvoll auf der Oberfläche abgesetzt wird, dann kann es durch die auftretenden Kräfte leicht zu einer Schädigung des Bauteils kommen. Wenn also die genaue Höhe der Bestückungsoberfläche aufgrund individueller Verwölbungen nicht bekannt ist, dann muss die der Bestückungskopf zunächst in einem vergleichsweise großen Abstand über der Oberfläche positioniert werden und von dort aus die restliche Annäherung an die Oberfläche mit einer geringen Geschwindigkeit vornehmen. Als Resultat ergibt sich eine deutlich höhere Prozesszeit als bei einem ideal planaren Schaltungsträger, bei dem vor diesem finalen Absetzen ein geringerer Sicherheitsabstand eingehalten werden müsste.

Ähnliche Schwierigkeiten ergeben sich auch bei anderen Prozessschritten, bei denen eine dreidimensional positionierbare Einrichtung an die Schaltungsträger-Oberfläche angenähert wird. So können zum Beispiel in manchen Verfahrensschritten auch Dosierwerkzeuge oder Messwerkzeuge zum Einsatz kommen, welche ebenfalls in möglichst genau definierter Weise an eine Oberfläche des Schaltungsträgers angenähert werden sollen, um an einer gegebenen lateralen Position entweder eine Materialschicht aufzutragen oder eine physikalische Messung vorzunehmen. Auch hier soll eine Zielposition mit einem möglichst genau definierten Abstand zu einer tatsächlichen Schaltungsträgeroberfläche möglichst schnell angefahren werden, wobei gleichzeitig eine Beschädigung der gerade prozessierten Baugruppe sicher vermieden werden muss.

Aufgabe der Erfindung ist es daher, ein Verfahren zur Herstellung von elektronischen Baugruppen anzugeben, welches die genannten Nachteile überwindet. Insbesondere soll ein Verfahren zur Verfügung gestellt werden, welches eine deutlich höhere Prozessgeschwindigkeit und/oder ein niedrigeres Beschädigungsrisiko bei einer dreidimensionalen Positionierungsaufgabe relativ zur Schaltungsträger-Oberfläche ermöglicht. Eine weitere Aufgabe ist es, eine Fertigungsanlage anzugeben, welche zur Durchführung des Verfahrens ausgelegt ist.

Diese Aufgaben werden durch das in Anspruch 1 beschriebene Verfahren und die in Anspruch 15 beschriebene Fertigungsanlage gelöst.

Das erfindungsgemäße Verfahren dient der Herstellung von elektronischen Baugruppen mittels einer Fertigungsanlage mit ein oder mehreren Prozessvorrichtungen. Es umfasst die folgenden Verfahrensschritte:
a) sequenzielles Beladen der Fertigungsanlage mit einer Mehrzahl von elektrischen Schaltungsträgern,
b) Bereitstellen einer Mehrzahl von Geometrie-Datensätzen zu den einzelnen Schaltungsträgern,
   - wobei die einzelnen Geometrie-Datensätze jeweils eine Vielzahl von Ortsvektoren (x,y,z) aufweisen,
   - wobei jeder Ortsvektor ein laterales Koordinatenpaar (x,y) für die Position innerhalb der Schaltungsträgerebene und eine zugeordnete Höhenkoordinate (z) enthält,
c) sequenzielle Prozessierung der einzelnen Schaltungsträger in einer ausgewählten Prozessvorrichtung, welche eine dreidimensional positionierbare Einrichtung enthält,
   - wobei für den jeweils zu prozessierenden Schaltungsträger der ihm zugeordneten Geometrie-Datensatz verwendet wird,
      um zu einer vorgegebenen lateralen Zielposition (x,y) der positionierbaren Einrichtung eine zugehörige Ziel-Höhenkoordinate (z1) zu ermitteln
      und die Einrichtung bei der lateralen Zielposition (x,y) in dieser Ziel-Höhenkoordinate zu positionieren.

Es handelt sich also um ein Verfahren der Serienfertigung, bei dem eine Serie von elektrischen Schaltungsträgern nacheinander prozessiert wird. Dabei kann insbesondere eine Serie von untereinander nominell gleichen Baugruppen hergestellt werden, also von Baugruppen mit demselben nominellen Layout. Dabei soll allerdings auch nicht ausgeschlossen sein, dass von Zeit zu Zeit (z.B. innerhalb einer Fertigungsschicht) eine Umstellung auf eine andere Serie erfolgen, bei welcher die Layout-Parameter verändert sind.

Die einzelnen Eingangssubstrate, also die zu prozessierenden elektrischen Schaltungsträger können nominell untereinander die gleiche Geometrie aufweisen, oder es kann auch hier von Zeit zu Zeit zu einer Umstellung kommen. So kann beispielsweise gelegentlich eine Umstellung auf Schaltungsträger eines anderen Herstellers und/oder einer anderen Materialzusammensetzung und/oder mit anderen seitlichen Abmessungen, Schichtdicken bzw. Leiterbahnverläufen vorgenommen werden. Selbst wenn die einzelnen elektrischen Schaltungsträger einer Serie untereinander nominell gleich sind, kommt es aber in der Praxis zu unterschiedlich ausgeprägten Verwölbungen, so dass die genauen Höhenprofile der einzelnen Schaltungsträger von Stück zu Stück schwanken. Um die unerwünschten Effekte dieser geometrischen Schwankungen abzumildern, werden beim erfindungsgemäßen Verfahren individuelle Geometrie-Datensätze bereitgestellt, welche den einzelnen Schaltungsträgern zugeordnet sind. Insbesondere liegt dabei zu jedem individuellen Schaltungsträger zumindest ein zugeordneter Geometrie-Datensatz vor. Dieser Geometrie-Datensatz kann in der Fertigungsanlage dauerhaft gespeichert sein, er kann jedoch optional auch nur temporär vorgehalten werden. Wesentlich ist, dass dieser Geometrie-Datensatz zu einer bestimmten Zeit, während der zugeordnete Schaltungsträger in der Anlage prozessiert wird, zur Verfügung steht und in Schritt c) bei der Einstellung einer ausgewählten Prozessvorrichtung verwendet wird.

Die einzelnen Geometrie-Datensätze umfassen jeweils eine Vielzahl von Ortsvektoren mit x-,y- und z-Koordinaten. Die x- und y-Koordinaten geben dabei die laterale Position innerhalb der Schaltungsträger-Oberfläche an, also mit anderen Worten die Position im planaren Layout. Die z-Koordinate gibt dazu eine zugeordnete Höhenkoordinate an, welche insbesondere eine Lage der Schaltungsträger-Oberfläche bei dieser lateralen Position repräsentiert. Auf diese Weise können mit der z-Koordinate leichte Abweichungen von der nominell planaren Ausgestaltung der Schaltungsträger-Flächen erfasst werden. Wenn der Schaltungsträger auf beiden Hauptflächen prozessiert wird, dann kann zu jeder dieser beiden Seiten ein entsprechendes Höhenprofil bereitgestellt werden. Die Vielzahl von Ortsvektoren in den einzelnen Geometrie-Datensätzen können als Netz von Stützpunkten betrachtet werden. Da ein solches Netz nicht beliebig dicht ist, ist nicht für jede laterale x,y-Position ein zugeordneter Höhenwert z exakt bekannt. Er kann jedoch durch Interpolation aus benachbarten bekannten Stützpunkten näherungsweise ermittelt werden. So kann für jede gegebene x,y-Position, welche im Rahmen der Prozessierung des Schaltungsträgers relevant wird, ein zugehöriger Höhenwert z ermittelt werden und insbesondere in Schritt c) als Zielposition für eine zu positionierende Einrichtung verwendet werden.

Wesentlich im Zusammenhang mit der vorliegenden Erfindung ist vor allem, dass in Schritt c), bei der eine dreidimensional positionierbare Einrichtung zum Einsatz kommt, die tatsächliche Höheninformation z bei der Positionierung dieser Einrichtung verwendet wird. Unter Nutzung dieser Information über die individuelle Abweichung des aktuell prozessierten Schaltungsträgers von der planaren Soll-Geometrie wird nämlich dann eine von der Einrichtung anzufahrende Ziel-Höhenkoordinate festgelegt. Mit anderen Worten wird zu einer vorgegebenen lateralen x,y-Zielposition, die während der Fertigung von dieser Einrichtung angefahren soll, eine zugehörige Ziel-Höhenkoordinate angesteuert, welche sich nicht aus der reinen Soll-Geometrie des Schaltungsträgers ableitet, sondern die die individuelle Abweichung und insbesondere die Verwölbung eines jeden Schaltungsträgers berücksichtigt. Auf diese Weise ist es möglich, bei der initialen Positionierung dieser ausgewählten Einrichtung einen deutlich geringeren Sicherheitsabstand zur Schaltungsträgeroberfläche einzuhalten, als dies bei Verwendung der rein nominellen, planaren Oberflächengeometrie möglich wäre. Insbesondere wird dann während der Serienfertigung von Schaltungsträger zu Schaltungsträger für eine gegebene laterale x,y-Position die zugehörige Ziel-Höhenkoordinate jeweils unterschiedlich gewählt. Zumindest ist dies für die überwiegende Zahl von individuellen Schaltungsträgern der Fall. Ein gelegentliches, zufälliges Zusammentreffen der tatsächlichen Ziel-Höhenkoordinaten an einer gegebenen Stelle soll dabei natürlich nicht ausgeschlossen sein.

Ein wesentlicher Vorteil des erfindungsgemäßen Verfahrens ist, dass durch die beschriebene Nutzung der tatsächlichen Höheninformation bei der Positionierung eine Annäherung der positionierbaren Einrichtung an die Schaltungsträger-Oberfläche deutlich schneller und präziser erfolgen kann. Bei der von der Einrichtung angesteuerten Ziel-Höhenkoordinate liegt typischerweise noch ein Rest-Abstand zur Schaltungsträger-Oberfläche vor, der von dieser initialen Ziel-Position aus noch weiter reduziert werden kann, so dass insbesondere am Schluss sogar eine Berührung der Schaltungsträger-Oberfläche erfolgt. Diese finale Annäherungsphase kann aber wesentlich verkürzt werden, wenn die initiale Ziel-Position schon sehr nah an der Oberfläche liegt. Dies kann mit dem erfindungsgemäßen Verfahren erreicht werden, wobei unter Nutzung der tatsächlichen Höheninformation das Risiko einer vorzeitigen Kollision vorteilhaft vermieden oder zumindest wesentlich reduziert ist. So kann mit dem erfindungsgemäßen Verfahren die Dauer eines solchen Positionierungs-Schritts insgesamt reduziert werden, wobei gleichzeitig das Risiko einer Beschädigung durch Kollision mit der Oberfläche im Vergleich zum Stand der Technik verringert ist.

Die erfindungsgemäße Fertigungsanlage dient zur Herstellung von elektronischen Baugruppen und ist zur Durchführung des erfindungsgemäßen Verfahrens ausgelegt. Hierzu weist sie die in Anspruch 15 beschriebenen Merkmale auf. Die Vorteile der erfindungsgemäßen Fertigungsanlage ergeben sich analog zu den vorab beschriebenen Vorteilen des erfindungsgemäßen Verfahrens. Insbesondere ist auch die Fertigungsanlage dazu ausgelegt, in Schritt c) von Schaltungsträger zu Schaltungsträger die zu einer lateralen x,y-Zielposition gehörende Höhenkoordinate z in Abhängigkeit von dem zugeordneten Geometrie-Datensatz unterschiedlich zu wählen.

Vorteilhafte Ausgestaltungen und Weiterbildungen der Erfindung gehen aus den von Anspruch 1 abhängigen Ansprüchen sowie der folgenden Beschreibung hervor. Dabei können die beschriebenen Ausgestaltungen des Verfahrens und der Fertigungsanlage allgemein vorteilhaft miteinander kombiniert werden.

Gemäß einer besonders bevorzugten Ausführungsform ist die ausgewählte Prozessvorrichtung eine Bestückungsvorrichtung, und die dreidimensional positionierbare Einrichtung ein Bestückungskopf. Unter einem "Bestückungskopf" soll hier derjenige Teil der Bestückungsvorrichtung verstanden werden, welcher das zu bestückende Bauteil trägt und zusammen mit diesem dreidimensional positionierbar ist. Gemeint ist hier also das eigentliche Bestückungswerkzeug - selbst wenn es nicht die Form eines Kopfes aufweisen sollte.

Bei dieser Ausführungsform wird bei Schritt c) in der jeweils vorgegebenen lateralen x,y-Zielposition der Bestückungskopf zusammen mit dem zu bestückenden Bauteil in die Ziel-Höhenkoordinate z1 positioniert. Anschließend wird der Schaltungsträger in der lateralen Zielposition mit dem Bauteil bestückt.

Allgemein kann der Schaltungsträger innerhalb der Bestückungsvorrichtung mit mehreren elektronischen Bauteilen bestückt werden. Dies kann entweder mit einem Bestückungskopf sequenziell hintereinander erfolgen oder aber auch durch die Verwendung von mehreren Bestückungsköpfen zumindest teilweise parallelisiert werden.

Um die Bestückung des Schaltungsträgers mit dem jeweiligen Bauteil abzuschließen, kann im Anschluss an die Positionierung des Bestückungskopfes in der Ziel-Höhenkoordinate z1 eine Absenkung des Bestückungskopfes in eine Absetzposition erfolgt, aus welcher insbesondere das zu bestückende Bauteil auf dem Schaltungsträger abgesetzt wird.
Mit anderen Worten wird die in Schritt c) eingenommene Position mit den Koordinaten x,y und z1 als initiale Zielposition verwendet, um anschließend von dort aus eine endgültige Annäherung an den Schaltungsträger vorzunehmen. Diese finale Annäherung in die endgültige Absetzposition kann insbesondere mit einer (im Verhältnis zum Anfahren der initialen Zielposition) deutlich reduzierten Geschwindigkeit erfolgen. Die endgültige Annäherung zum Absetzen kann insbesondere unter kontinuierlicher Überwachung der einwirkenden Absetzkraft durchgeführt werden, um eine plötzliche Kollision zu vermeiden.

Durch die erfindungsgemäße Bereitstellung und Nutzung des individuellen Höhenprofils kann bei der initialen Zielposition x,y,zl (also vor dem endgültigen Absetzvorgang) der Abstand zwischen zu bestückendem Bauteil und Schaltungsträger-Oberfläche sehr klein gewählt sein. Das Anfahren dieser initialen Zielposition dicht beim Schaltungsträger kann im Verhältnis zum endgültigen Absetzen sehr schnell erfolgen. Wenn beim endgültigen Absetzen unter Kontrolle der Setzkraft nur noch eine kleine Reststrecke überwunden werden muss, kann auf diese Weise der Bestückungsvorgang wesentlich beschleunigt werden.

Alternativ zu der vorab beschriebenen Ausführungsform kann die dreidimensional positionierbare Einrichtung aber auch eine Dosiereinrichtung oder eine Messeinrichtung sein. Eine Dosiereinrichtung kann beispielsweise dazu ausgelegt sein, um eine Beschichtung strukturiert auf einer Oberfläche des Schaltungsträgers aufzubringen. So können beispielsweise mit einem Dispenser einzelne Klebepunkte aufgebracht werden. Alternativ kann eine Messeinrichtung mit einem dreidimensional positionierbaren Messkopf vorgesehen sein, um eine physikalische Eigenschaft des gerade prozessierten Schaltungsträgers zu messen. So können hier beispielsweise elektrische Messspitzen aufgesetzt werden, oder es kann ein optischer Messkopf in einem Soll-Abstand über dem Schaltungsträger positioniert werden. Auch in diesen Fällen erlaubt die Nutzung der individuellen dreidimensionalen Oberflächenstruktur ein besonders schnelles und präzises Positionieren der relevanten Einrichtung in einem vorbestimmten Abstand über dieser Oberfläche.

Allgemein ist es besonders vorteilhaft, wenn die elektrischen Schaltungsträger Leiterplatten sind. Diese Leiterplatten können jeweils ein oder mehrere Schichten aus einem elektrisch isolierenden Material und eine Mehrzahl von Leiterbahnen aufweisen. Das isolierende Material kann dabei ein organisches Material sein oder zumindest eine organische Materialkomponente umfassen. Es kann beispielsweise ein Verbundwerkstoff sein, insbesondere ein faserverstärkter Kunststoff. Bei Leiterplatten mit solchen Verbundwerkstoffen kommt es abhängig von genauen Herstellungsverfahren besonders häufig zu Verwölbungen aus der nominellen Leiterplattenebene heraus. Daher kommen die Vorteile der Erfindung hier besonders wirksam zum Tragen.

Alternativ ist es aber grundsätzlich auch möglich, dass der Schaltungsträger ein anorganischer Schaltungsträger ist. So kann beispielsweise auch ein keramisches Substrat als Schaltungsträger dienen. Bei solchen keramik-basierten Schaltungsträgern ist zwar meist die Verwölbung deutlich geringer ausgeprägt als bei klassischen Verbund-Leiterplatten. Bei einer zunehmenden Präzision in der Positionierung eines Werkzeuges (insbesondere eines Bestückers) kann es jedoch auch hier zweckmäßig sein, die individuellen Abweichungen von der nominellen Geometrie der Substrate zu berücksichtigen.

Allgemein kann die Fertigungsanlage mehrere, von den einzelnen Schaltungsträgern sequenziell zu durchlaufende Prozessvorrichtungen aufweisen, welche den einzelnen Stationen des Herstellungsverfahrens entsprechen. Zusätzlich kann sie eine Fördereinrichtung aufweisen, mit welcher die Schaltungsträger durch diese einzelnen Prozessstationen hindurch gefördert werden können. Hierzu kann beispielsweise eine lineare Transportrichtung vorgesehen sein.

Um die einzelnen Schaltungsträger eindeutig zu identifizieren, kann jeder von ihnen eine eindeutige Markierung aufweisen, welche mit einem Lesegerät ausgelesen wird. Dies erlaubt eine eineindeutige Zuordnung des jeweiligen Schaltungsträgers und insbesondere auch eine Zuordnung des zugehörigen Geometrie-Datensatzes zu diesem Schaltungsträger. Bei der verwendeten Markierung kann es sich beispielsweise um einen Barcode handeln. Das Auslesen der Markierung mit dem entsprechenden Lesegerät kann grundsätzlich bereits vor dem Beladen der Anlage mit den Schaltungsträgern erfolgen. Besonders bevorzugt ist es jedoch, wenn das Auslesen und die entsprechende Zuordnung des individuellen Schaltungsträgers (gegebenenfalls ein weiteres Mal) innerhalb der Fertigungsanlage erfolgt.

Allgemein und unabhängig davon, wie die einzelnen Schaltungsträger in der Anlage identifiziert werden, ist es vorteilhaft, wenn jedem Schaltungsträger zumindest ein Geometrie-Datensatz eindeutig zugeordnet ist. So wird zweckmäßig für wenigstens eine der beiden Hauptflächen jedes Schaltungsträgers ein eigenes Höhenprofil bereitgestellt.

Bei einer vorteilhaften Ausführungsform des Verfahrens werden die einzelnen Schaltungsträger beidseitig prozessiert. Mit anderen Worten erfolgt für jede der beiden gegenüberliegenden Hauptflächen eine eigene Prozessierung. So kann insbesondere auf beiden Hauptflächen eine Bestückung mit ein oder mehreren elektronischen Bauteilen erfolgen. Hierzu kann entweder dieselbe Fertigungsanlage von jedem Schaltungsträger zweimal durchlaufen werden oder es kann eine längere Fertigungsanlage zum Einsatz kommen, bei welcher die relevante Abfolge von Prozessvorrichtungen zweimal hintereinander enthalten ist. Zweckmäßigerweise ist die jeweils zu prozessierende Oberfläche in dem relevanten Teilprozess nach oben orientiert, so dass die zu bestückenden Bauteile und aufgebrachten Schichten durch die Schwerkraft (ggf. in Kombination mit einer Haftung durch eine darunterliegende Lot- oder Kleberschicht) auf der Oberfläche gehalten werden. In diesem Fall erfolgt zwischen den Teilprozessen für die beiden Substratseiten zweckmäßigerweise ein Wenden der Schaltungsträger.

Bei der beidseitigen Prozessierung der Schaltungsträger ist es allgemein besonders bevorzugt, wenn für jede der beiden Hauptflächen separate Geometrie-Datensätze bereitgestellt und verwendet werden. Näherungsweise kann jedoch aus dem Geometrie-Datensatz für die erste Hauptfläche der Geometrie-Datensatz für die gegenüberliegende, zweite Hauptfläche abgeleitet werden. Dies gilt insbesondere dann, wenn die Dicke des Schaltungsträgers annähernd konstant ist. Dann kann aus der Unebenheit der einen Fläche unter Annahme einer Gesamt-Verwölbung auf eine entsprechende Unebenheit der gegenüberliegenden Oberfläche geschlossen werden.

Allgemein und unabhängig von der genauen Ausführung der positionierbaren Einrichtung können durch diese in Schritt c) mehrere laterale Zielpositionen nacheinander angefahren werden, wobei jeweils eine Positionierung der Einrichtung in der zugeordneten Ziel-Höhenkoordinate (z1) erfolgt. Insbesondere sind diese Höhenkoordinaten wiederum im Wesentlichen von lateraler Position zu lateraler Position unterschiedlich und kennzeichnen somit die Verwölbung des jeweiligen Schaltungsträgers. Insbesondere können bei dieser Ausführungsform mit demselben Bestückungskopf mehrere elektronische Bauteile nacheinander unter Anpassung der individuellen Absetzhöhe an unterschiedlichen lateralen Positionen bestückt werden.

Gemäß einer besonders bevorzugten Ausführungsvariante wird der zu jedem Schaltungsträger zugehörige Geometrie-Datensatz innerhalb der Fertigungsanlage (also mit anderen Worten "inline") ermittelt. Die Ermittlung dieser Geometrie-Datensätze kann in einer Prozessvorrichtung erfolgen, welche der Prozessvorrichtung mit der genannten dreidimensional positionierbaren Einrichtung vorgelagert ist. Zweckmäßig werden diese Geometrie-Datensätze im vorgegebenen Prozesstakt ermittelt.

Diese vorgelagerte Ermittlung der einzelnen Geometrie-Datensätze kann besonders vorteilhaft in einer vorgelagerten optischen Inspektionsvorrichtung erfolgen. Dabei kann es sich beispielsweise um eine Lotpasteninspektionsvorrichtung handeln (SPI für englisch "solder paste inspection"), welche in den gängigen Fertigungsanlagen für elektronische Baugruppen ohnehin meist vorliegt. In dieser Vorrichtung kann zusätzlich zu der optischen Kontrolle einer zuvor aufgetragenen Lotpaste eine Erfassung des individuellen Höhenprofils durch optische Messung erfolgen. Alternativ kann die Ermittlung des jeweiligen Geometrie-Datensatzes aber auch in einer beliebigen anderen Art von optischer Inspektionsvorrichtung erfolgen, beispielsweise auch in einer der ersten Bestückungsvorrichtung nachgelagerten automatisierten optischen Inspektionsvorrichtung für den Bestückungsprozess (AOI für englisch "automated optical inspection"). Auch wenn eine solche AOI-Vorrichtung der ersten Bestückungsprozess nachgelagert ist, so kann sie dennoch einem Bestückungsschritt für die zweite Schaltungsträgerseite vorgelagert sein. In diesem Fall können die gemessenen AOI-Daten der ersten Substratseite (z.B. unter der Annahme konstanter Substratdicke) dazu verwendet werden, um das Oberflächenprofil für die gegenüberliegende, zweite Substratseite abzuleiten und dieses bei der Prozessierung der zweiten Substratseite zu verwenden.

Allgemein und unabhängig von der genauen Realisierung der optischen Inspektionsvorrichtung kann eine Datenübermittlung von dieser Inspektionsvorrichtung an die nachgelagerte ausgewählte Prozessvorrichtung erfolgen. So wird hier insbesondere der Geometrie-Datensatz des jeweils inspizierten Schaltungsträgers in der optischen Inspektionsvorrichtung erfasst und an die nachgelagerte ausgewählte Prozessvorrichtung übertragen. Bei der entsprechenden Ausführungsform der Fertigungsanlage ist hierfür zwischen der optischen Inspektionsvorrichtung und der nachgelagerten ausgewählten Prozessvorrichtung eine Datenschnittstelle vorgesehen.

Alternativ oder zusätzlich zu der beschriebenen "Inline"-Ermittlung der Geometrie-Datensätze können diese aber auch bereits vor dem Durchlaufen der Fertigungsanlage bestimmt werden und somit der Fertigungsanlage bereits als Eingangs-Datensatz zur Verfügung gestellt werden. Dazu kann beispielsweise für jeden Schaltungsträger ein von dessen Hersteller ermittelter und zur Verfügung gestellter Geometrie-Datensatz eingelesen werden. Alternativ kann ein solcher Eingangs-Datensatz aber auch von dem Betreiber der Fertigungsanlage vor dem Beladen der Anlage als Eingangs-Datensatz erzeugt werden.

Grundsätzlich ist es möglich, dass im gesamten Fertigungsverfahren nur diese Eingangs-Datensätze verwendet werden, um die Prozessierung der Substrate auf die individuellen Höhenprofile anzupassen. Dies kann vor allem dann ausreichend sein, wenn jeder Schaltungsträger nur einseitig prozessiert wird, so dass nur ein Bestückungsvorgang nötig ist und dieser vor dem ersten Hochtemperatur-Prozess erfolgt (also insbesondere vor einem Reflow-Lötprozess). In einem solchen Fall kann davon ausgegangen werden, dass sich die initiale Verwölbung des Schaltungsträgers zwischen dem Beladen der Fertigungsanlage und dem (einzigen) Bestückungsprozess nicht entscheidend verändert.

Bei einem komplexeren Herstellungsverfahren und insbesondere bei einer zweiseitigen Prozessierung der einzelnen Schaltungsträger ist es jedoch allgemein vorteilhaft, wenn die Geometrie-Datensätze der einzelnen Schaltungsträger zumindest teilweise innerhalb der Fertigungsanlage ermittelt werden. Dabei soll jedoch nicht ausgeschlossen sein, dass ein vorab ermittelter Eingangs-Datensatz als initialer Geometrie-Datensatz eingelesen wird und dieser dann während der Prozessierung des jeweiligen Schaltungsträgers durch ein oder mehrere weitere Messungen innerhalb der Fertigungsanlage aktualisiert, ersetzt und/oder verfeinert wird.

Bei einer weiteren vorteilhaften Ausführungsform des Verfahrens können die Höhenkoordinaten der einzelnen Geometrie-Datensätze zumindest teilweise die Höhe einer auf dem jeweiligen Schaltungsträger aufgetragenen Materialschicht beschreiben. Bei einer solchen Materialschicht kann es sich insbesondere um eine Lotpastenschicht, eine Sinterpastenschicht und/oder um eine Kleberschicht handeln. Es kann sich also insbesondere um eine Höheninformation zur Oberfläche einer nassen Materialschicht handeln, auf welche das zu bestückendes Bauteil aufgesetzt wird. Dabei kann entweder ein komplexeres Höhenprofil einer solchen zusätzlichen Materialschicht im Geometrie-Datensatz enthalten sein (also beispielsweise die genaue Form eines Lotpasten-Depots) oder auch nur eine Information über eine mittlere Höhe einer solchen lokalen Materialschicht. Die Information über die Oberfläche einer solchen zusätzlichen Materialschicht kann insbesondere in Schritt c) bei der Ermittlung der Ziel-Höhenkoordinate mit berücksichtigt werden. So können beispielsweise auch Schwankungen in der Dicke einer individuellen Lotpastenschicht bei der Bestimmung der optimalen Bestückungshöhe berücksichtigt werden.

Bei der letztgenannten Ausführungsform kann die Information über das Höhenprofil der weiteren Materialschicht entweder das Höhenprofil des jeweiligen Schaltungsträgers lokal ersetzen, oder das Höhenprofil der weiteren Materialschicht kann zusätzlich zum Höhenprofil der Schaltungsträger-Oberfläche im Geometrie-Datensatz enthalten sein. Bei der zweiten Variante, bei der beide Grenzflächen bekannt sind, kann die optimale Zielposition der positionierbaren Einrichtung besonders präzise bestimmt werden.

Nachfolgend wird die Erfindung anhand einiger bevorzugter Ausführungsbeispiele unter Bezugnahme auf die angehängten Zeichnungen beschrieben, in denen:
- Figur 1: eine schematische Darstellung einer Fertigungsanlage nach einem ersten Beispiel der Erfindung zeigt,
- Figur 2: einen schematischen Ausschnitt einer solchen Anlage und die zugehörige Übermittlung eines Geometrie-Datensatzes zeigt und
- Figur 3: einen schematischen Querschnitt eines zu prozessierenden Schaltungsträgers zeigt.

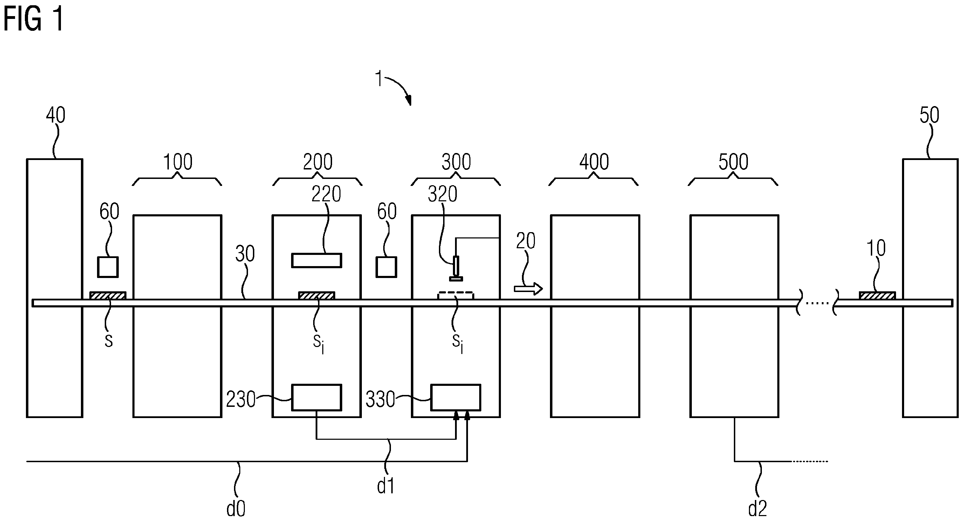

In den Figuren sind gleiche oder funktionsgleiche Elemente mit gleichen Bezugszeichen versehen. In Figur 1 ist eine Fertigungsanlage 1 gezeigt, welche zur Durchführung des erfindungsgemäßen Verfahrens ausgelegt ist. Die Fertigungsanlage 1 dient der automatisierten Serienfertigung einer Vielzahl von elektronischen Baugruppen 10. Diese Baugruppen 10 werden hergestellt, indem eine Vielzahl von entsprechenden Substraten s entlang einer Prozessrichtung 20 durch die Anlage hindurch gefördert wird. Dies Substrate s sind einzelne Schaltungsträger. Hierzu ist eine Fördereinrichtung 30 vorgesehen, welche die einzelnen Schaltungsträger s von einem Eingangsstapler 40 zu einem Ausgangsstapler 50 transportiert. Im Bereich des Eingangsstaplers 40 handelt es sich bei den Substraten noch um nackte Schaltungsträger. Im Bereich des Ausgangsstaplers handelt es sich dagegen um fertige elektronische Baugruppen 10, welche insbesondere mit einer Vielzahl von elektronischen Komponenten bestückt und elektrisch verbunden sein können.

Zwischen dem Eingangsstapler 40 und dem Ausgangsstapler 50 passieren die zu prozessierenden Substrate s eine Mehrzahl von Prozessvorrichtungen, von denen hier exemplarisch eine Druckvorrichtung 100, eine Inspektionsvorrichtung 200, eine Bestückungsvorrichtung 300, eine Reflow-Lötvorrichtung 400 und eine weitere Inspektionsvorrichtung 500 zur Prozessierung der ersten Substratseite dargestellt sind. Im Anschluss an die letzte Inspektionsvorrichtung 500 kann optional noch eine Anzahl weiterer Prozessvorrichtungen angeordnet sein, mit der das Substrat gewendet und anschließend auf seiner Rückseite weiter prozessiert werden kann. Diese werden hier nur zusammengefasst durch drei Punkte repräsentiert.

Um die einzelnen Schaltungsträger s eindeutig identifizieren zu können, sind an ausgewählten Stellen der Fertigungsanlage Lesegeräte 60 angeordnet, welche beispielsweise als Barcodeleser ausgestaltet sind. So kann genau bestimmt werden, welcher individuelle Schaltungsträger sᵢ zu einem gegebenen Zeitpunkt in welcher Prozessvorrichtung prozessiert wird. Der Index i bezeichnet daher im Folgenden einen bestimmten individuellen Schaltungsträger.

Erfindungsgemäß wird in einer ausgewählten Prozessvorrichtung zu dem jeweils zu prozessierenden Schaltungsträger sᵢ ein zugeordneter Geometrie-Datensatz gᵢ bereitgestellt und zumindest in einer ausgewählten Prozessvorrichtung für eine exakte dreidimensionale Positionierung verwendet. Im vorliegenden Beispiel ist diese ausgewählte Prozessvorrichtung die Bestückungsvorrichtung 300, und deren dreidimensional positionierbare Einrichtung ist ein Bestückungskopf 320. Der zu jedem individuellen Schaltungsträger sᵢ zugeordnete Geometrie-Datensatz gᵢ kann entweder gemäß Datenfluss dem d0 aus vorbekannten Daten in die Fertigungsanlage 1 eingelesen werden oder aber er kann "inline" also innerhalb der Fertigungsanlage gemessen werden. Die zweite Alternative ist besonders bevorzugt und ist daher beim Beispiel der Figur 1 umgesetzt: Hier wird innerhalb der Inspektionsvorrichtung 200 mit einer optischen Messmethode der jeweilige Geometrie-Datensatz gᵢ ermittelt und gemäß Datenfluss d1 an die nachfolgende Bestückungsvorrichtung 300 übertragen. Die Inspektionsvorrichtung 200 kann beispielsweise eine optische Lotpasteninspektionsvorrichtung sein, welche ein optisches Messsystem 220 aufweist. Dies kann beispielsweise dazu dienen, eine mit der vorgelagerten Druckvorrichtung 100 strukturiert aufgebrachte Lotpaste auf ihre Druckqualität hin zu überwachen. Zusätzlich können die hier generierten optischen Messdaten dazu genutzt werden, den erfindungsgemäß verwendeten Geometrie-Datensatz gᵢ für das jeweils aktuelle Substrat sᵢ bereitzustellen. Die Übermittlung der Daten kann von einer optional vorhandenen Datenspeichervorrichtung 230 des Lotpasteninspektionssystems an eine ebenfalls optional vorhandene Datenspeichervorrichtung 330 der Bestückungsvorrichtung 300 erfolgen. Innerhalb der Bestückungsvorrichtung 300 werden die gemäß d0 und/oder gemäß d1 übermittelten Geometrie-Datensätze gᵢ verwendet, um für jeden individuellen Schaltungsträger sᵢ eine individuelle Anpassung der Bestückungshöhe zu ermöglichen. Optional kann auch in der nachgelagerten Inspektionsvorrichtung 500 ein (weiterer) Geometrie-Datensatz für die einzelnen Schaltungsträger erzeugt werden. Hierin kann insbesondere eine nach dem Reflow-Löten in der Vorrichtung 400 eingetretene Veränderung der individuellen Verwölbung berücksichtigt sein. Diese Daten können gemäß Pfeil d2 zu dem optionalen weiteren Bestücker übermittelt werden, welcher beim Prozessieren der Rückseite zum Einsatz kommen kann. Die Oberflächendaten der Rückseite können dann beispielsweise unter der Annahme einer konstanten Substratdicke aus den gemessenen Daten der Vorderseite abgeleitet werden.

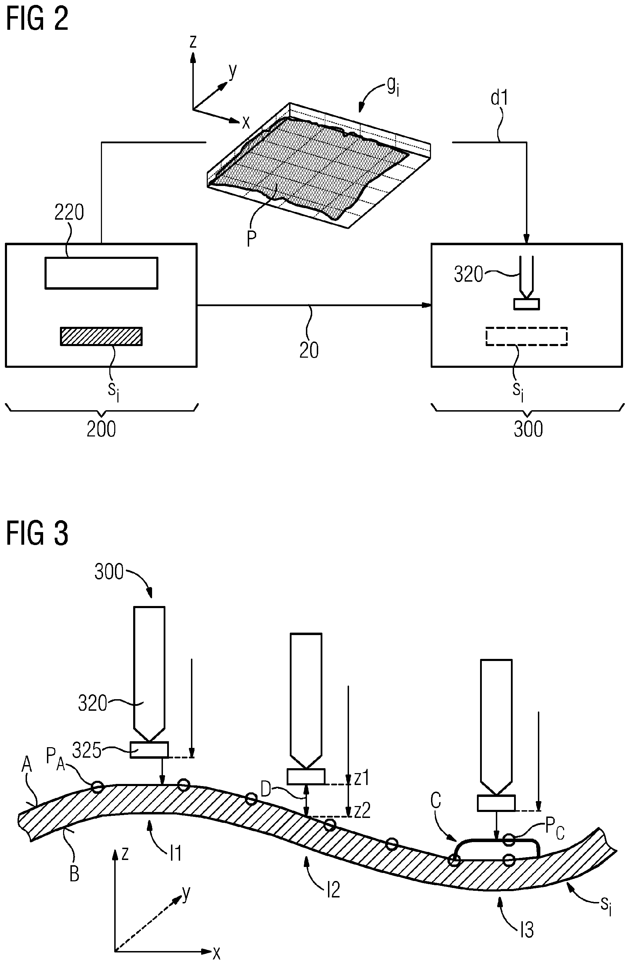

In Figur 2 ist ein schematischer Ausschnitt einer solchen Fertigungsanlage 1 dargestellt, nämlich ein Teilabschnitt der Anlage im Bereich der Inspektionsvorrichtung 200 und der Bestückungsvorrichtung 300. Die Fördervorrichtung für die Schaltungsträger s ist hier der Übersichtlichkeit halber weggelassen und nur durch die Prozessrichtung 20 angedeutet. Analog wie beim Beispiel der Figur 1 ist die Vorrichtung 200 eine Lotpasteninspektionsvorrichtung, und hier wird zu jedem darin inspizierten Schaltungsträger sᵢ ein zugehöriger Geometrie-Datensatz gᵢ ermittelt und gemäß dem Pfeil d1 an die nachfolgende Bestückungsvorrichtung 300 übertragen. Durch die schematische Skizze des Geometrie-Datensatzes gᵢ soll veranschaulicht werden, dass dieser geometrische Daten der gemessenen Schaltungsträgeroberfläche enthält und zwar in Form einer Mehrzahl von Stützpunkten, die zusammen auf dieser Oberfläche liegen und jeweils durch einen kartesischen Ortsvektor (x,y,z) gegeben sind. Abhängig von der Anzahl der vorliegenden Stützpunkte liegt hier ein mehr oder weniger dichtes Netz an Koordinaten vor, durch welches die Form der jeweiligen Schaltungsträgeroberfläche wiedergegeben ist. Die in der Vorrichtung 200 inline vermessene und hier schematisch dargestellte Oberfläche kann beispielsweise die erste Seite des Schaltungsträgers sein (also die Oberseite A gemäß Figur 3), welche in den Vorrichtungen 100 bis 500 der Anlage prozessiert wird. Wenn der optisch vermessene Schaltungsträger sᵢ zu einem etwas späteren Zeitpunkt in der Bestückungsvorrichtung ankommt, dann wird die Positionierung des Bestückungskopfes 320 relativ zur Schaltungsträgeroberfläche unter Verwendung des Geometrie-Datensatzes gᵢ vorgenommen.

In Figur 3 ist schematisch dargestellt, wie ein solcher Geometrie-Datensatz gᵢ bei der Bestückung in der Bestückungsvorrichtung 300 berücksichtigt wird. Von dem aktuell dort zu bestückenden Schaltungsträger sᵢ ist ein Teilabschnitt im xz-Querschnitt gezeigt. In diesem Querschnitt ist sowohl das Höhenprofil der obenliegenden Oberfläche A als auch das Höhenprofil der untenliegenden Oberfläche B zu erkennen. Um den Einfluss der Geometrie-Daten auf die Positionierung des Bestückungskopfes 320 zu verdeutlichen, ist die Verwölbung des Schaltungsträgers stark übertrieben dargestellt. Der Schaltungsträger kann insbesondere eine dünne Leiterplatte sein, welche bei annähernd konstanter Dicke bedingt doch ihren Herstellungsprozess aus der planaren Geometrie herausgewölbt ist. Nur beispielsweise kann dies eine wellenartige Verbiegung sein, wie in Figur 3 gezeigt. Der Geometrie-Datensatz weist für die geradezu prozessierende erste Seite A eine Anzahl von Stützpunkten P_{A} auf, welche auf dieser Oberfläche liegen. Einige von diesen über die ganze Oberfläche verteilten Stützpunkten P_{A} sind in Figur 3 zu erkennen. Durch eine Interpolation kann auch für laterale xy-Positionen zwischen diesen Stützpunkten jeweils eine zugehörige z-Koordinate näherungsweise ermittelt werden. Figur 3 zeigt nun, wie mit einem oder mehreren Bestückungsköpfen 320 ein elektronisches Bauteil 325 an verschiedenen lateralen xy-Positionen unter Nutzung dieser Höheninformation positioniert und abgesetzt werden kann. Beispielhaft sind hier drei laterale Bestückungspositionen 11, 12 und 13 gezeigt. Bei jeder dieser Bestückungspositionen wird abhängig von dem Geometrie-Datensatz aus den x- und y-Koordinaten eine zugehörige z-Koordinate für die Lage der Oberfläche bestimmt. Um trotzdem beim Bestücken einen Sicherheitsabstand zur Oberfläche A zu gewährleisten, wird der Bestückungskopf 320 mit dem Bauteil 325 aber nicht sofort bis ganz an diesen Punkt gefahren, sondern er wird zunächst an der lateralen Stelle x,y in eine initiale Ziel-Höhenkoordinate z1 gebracht, welche einen Sicherheitsabstand D zur Oberfläche A aufweist. Das Anfahren von oben in diese initiale Ziel-Position (x,y,z1) ist für jede der lateralen Positionen durch einen längeren Pfeil gekennzeichnet. Dieses erste Anfahren kann vergleichsweise schnell erfolgen. Danach erfolgt das endgültige Absenken in die auf der Schaltungsträgeroberfläche liegende Absetz-Position mit der Absetz-Höhenkoordinate z2. Es wird also jetzt noch weiter abgesenkt, und der Sicherheitsabstand D wird dabei auf Null reduziert. Dieses finale Absetzen (entsprechend den kürzeren senkrechten Pfeilen) kann vorteilhaft mit einer deutlich reduzierten Geschwindigkeit erfolgen, und es kann dabei insbesondere kontinuierlich die Setzkraft gemessen werden, um eine plötzliche Kollision zu vermeiden. Da bei diesem langsamen finalen Absetzen aber nur der kleine Rest-Abstand D überwunden werden muss und das Anfahren der initialen Ziel-Position (x,y,z1) vergleichsweise schnell ausgeführt werden kann, kann durch die Berücksichtigung der individuellen Höheninformation an jedem relevanten Absetzpunkt 11, 12, 13 bei der Bestückung relativ viel Zeit eingespart werden. Da die Bestückung auch innerhalb des gesamten Fertigungsverfahrens ein zeitintensiver Schritt ist, kann so der Prozesstakt beschleunigt werden, wobei trotzdem das Risiko einer Kollision des Bauteils 325 mit der Substratoberfläche A gering bleibt.

Bei der ganz rechts dargestellten lateralen Absetzposition 13 ist beispielhaft gezeigt, dass der Geometrie-Datensatz neben den Stützpunkten auf der oberen Schaltungsträgerseite P_{A} auch weitere Stützpunkte P_{C} umfassen kann, welche beispielsweise die Höhe eines Lotpastendepots C wiedergeben können. Bei einem noch dichteren Netz an solchen zusätzlichen Stützpunkten P_{C} könnte neben der (mittleren) Höhe auch die Form eines solchen Lotpastendepots wiedergeben werden. In jedem Fall kann die zusätzliche Information aus den Stützpunkten P_{C} dazu verwendet werden, ein zu bestückendes Bauteil 325 in der richtigen Höhe auf einem solchen Lotpastendepot C abzusetzen, wie im rechten Teil der Figur 3 beispielhaft dargestellt ist.

### Bezugszeichenliste

- 1: Fertigungsanlage
- 10: elektronische Baugruppe
- 20: Prozessrichtung
- 30: Fördereinrichtung
- 40: Einlaufstapler
- 50: Auslaufstapler
- 60: Lesegerät
- 100: Druckvorrichtung
- 200: Inspektionsvorrichtung (SPI)
- 220: optisches Messsystem
- 230: Datenspeichervorrichtung
- 300: Bestückungsvorrichtung
- 320: Bestückungskopf
- 325: Bauteil
- 330: Datenspeichervorrichtung
- 400: Lötvorrichtung
- 500: Inspektionsvorrichtung (AOI)
- A: erste Schaltungsträgerseite
- B: zweite Schaltungsträgerseite
- C: Lotpastendepot
- D: Sicherheitsabstand
- d0: Einlesen eines Geometrie-Datensatzes
- d1: Übermittlung eines Geometrie-Datensatzes
- d2: Übermittlung eines zweiten Geometrie-Datensatzes
- gᵢ: Geometrie-Datensatz
- 11: erste Bestückungsposition
- 12: zweite Bestückungsposition
- 13: dritte Bestückungsposition
- P: Stützpunkte
- P_{A}: Stützpunkt auf erster Schaltungsträgerseite
- P_{C}: Stützpunkt auf Oberfläche des Lotpastendepots
- s: Schaltungsträger
- Sᵢ: Schaltungsträger mit Index i
- x: laterale Koordinate
- y: laterale Koordinate
- z: Höhenkoordinate
- z1: initiale Ziel-Höhenkoordinate
- z2: Absetz-Höhenkoordinate

## Patentansprüche

1. Verfahren zu Herstellung von elektronischen Baugruppen (10) mittels einer Fertigungsanlage (1) mit ein oder mehreren Prozessvorrichtungen (100,200,300,400,500),
wobei das Verfahren die folgenden Verfahrensschritte aufweist:
a) sequenzielles Beladen der Fertigungsanlage (1) mit einer Mehrzahl von elektrischen Schaltungsträgern (s),
b) Bereitstellen einer Mehrzahl von Geometrie-Datensätzen (gᵢ) zu den einzelnen Schaltungsträgern (sᵢ),
- wobei die einzelnen Geometrie-Datensätze (gᵢ) jeweils eine Vielzahl von Ortsvektoren (x,y,z) aufweisen,
- wobei jeder Ortsvektor ein laterales Koordinatenpaar (x,y) für die Position innerhalb der Schaltungsträgerebene und eine zugeordnete Höhenkoordinate (z) enthält,
c) sequenzielle Prozessierung der einzelnen Schaltungsträger (sᵢ) in einer ausgewählten Prozessvorrichtung (300), welche eine dreidimensional positionierbare Einrichtung (320) enthält,
- wobei für den jeweils zu prozessierenden Schaltungsträger (sᵢ) der ihm zugeordneten Geometrie-Datensatz (gᵢ) verwendet wird,
um zu einer vorgegebenen lateralen Zielposition (x,y) der positionierbaren Einrichtung eine zugehörige Ziel-Höhenkoordinate (z1) zu ermitteln
und die Einrichtung bei der lateralen Zielposition (x,y) in dieser Ziel-Höhenkoordinate (z1) zu positionieren.

2. Verfahren nach Anspruch 1, bei welchem die ausgewählte Prozessvorrichtung eine Bestückungsvorrichtung (300) ist und die dreidimensional positionierbare Einrichtung ein Bestückungskopf (320) ist,
wobei in der jeweiligen vorgegebenen lateralen Zielposition (x,y) der Bestückungskopf (320) zusammen mit einem zu bestückenden Bauteil (325) in die Ziel-Höhenkoordinate (z1) positioniert wird,
um anschließend den Schaltungsträger (sᵢ) in der lateralen Zielposition (x,y) mit dem Bauteil (325) zu bestücken.

3. Verfahren nach Anspruch 2, bei welchem im Anschluss an die Positionierung des Bestückungskopfes (320) in der Ziel-Höhenkoordinate (z1) eine Absenkung des Bestückungskopfes (320) in eine Absetzposition (x,y,z2) erfolgt, aus welcher insbesondere das zu bestückende Bauteil (325) auf dem Schaltungsträger (sᵢ) abgesetzt wird.

4. Verfahren nach Anspruch 1, bei welchem die dreidimensional positionierbare Einrichtung (300) eine Dosiereinrichtung oder eine Messeinrichtung ist.

5. Verfahren nach einem der vorhergehenden Ansprüche, bei welchem die einzelnen elektrischen Schaltungsträger (sᵢ) als Leiterplatten ausgestaltet sind,
welche insbesondere ein oder mehrere Schichten aus einem elektrisch isolierenden Material und eine Mehrzahl von Leiterbahnen aufweisen.

6. Verfahren nach einem der vorhergehenden Ansprüche, bei welchem die Fertigungsanlage (1) mehrere, von den einzelnen Schaltungsträgern (sᵢ) sequenziell zu durchlaufende Prozessvorrichtungen (100,200,300,400,500) aufweist und eine Fördereinrichtung (30), mit welcher die Schaltungsträger (sᵢ) durch die Fertigungsanlage (1) hindurch gefördert werden können.

7. Verfahren nach einem der vorhergehenden Ansprüche, bei welchem jeder Schaltungsträger (sᵢ) eine eindeutige Markierung aufweist,
welche mit einem Lesegerät (60) ausgelesen wird,
wodurch eine eindeutige Zuordnung des jeweiligen Schaltungsträgers (sᵢ) erfolgt.

8. Verfahren nach einem der vorhergehenden Ansprüche, bei welchem jedem Schaltungsträger (sᵢ) zumindest ein Geometrie-Datensatz (gᵢ) eindeutig zugeordnet ist.

9. Verfahren nach einem der vorhergehenden Ansprüche, bei welchem jeder Schaltungsträger (sᵢ) zwei Hauptflächen (A,B) aufweist und für jede dieser beiden Hauptflächen (A,B) eine eigene Prozessierung erfolgt.

10. Verfahren nach einem der vorhergehenden Ansprüche, bei welchem in Schritt c) mit der dreidimensional positionierbaren Einrichtung (300) mehrere laterale Zielpositionen (11,12,13) nacheinander angefahren werden, wobei jeweils eine Positionierung der Einrichtung (300) in der zugeordneten Ziel-Höhenkoordinate (z1) erfolgt.

11. Verfahren nach einem der vorhergehenden Ansprüche, bei welchem der zu jedem Schaltungsträger (sᵢ) zugehörige Geometrie-Datensatz (gᵢ) innerhalb der Fertigungsanlage (1) ermittelt wird.

12. Verfahren nach Anspruch 11, bei welcher die Ermittlung der einzelnen Geometrie-Datensätze (gᵢ) in einer der ausgewählten Prozessvorrichtung (300) vorgelagerten optischen Inspektionsvorrichtung (200) erfolgt.

13. Verfahren nach einem der vorhergehenden Ansprüche, bei welchem zu jedem Schaltungsträger (sᵢ) ein zugehöriger Geometrie-Datensatz (gᵢ) bereits vor dem Durchlaufen der Fertigungsanlage ermittelt wird.

14. Verfahren nach einem der vorhergehenden Ansprüche, bei welchem die Höhenkoordinaten (z) der einzelnen Geometrie-Datensätze (sᵢ) zumindest teilweise die Höhe einer auf den Schaltungsträgern aufgetragenen Materialschicht ^{©} beschreiben.

15. Fertigungsanlage (1) zur Herstellung von elektronischen Baugruppen (10), welche zur Ausführung eines Verfahrens nach einem der vorstehenden Ansprüche ausgelegt ist,
wobei die Fertigungsanlage (1) folgende Vorrichtungen umfasst:
- ein oder mehrere Prozessvorrichtungen (100,200,300,400,500),
von denen zumindest eine ausgewählte Prozessvorrichtung (300) eine dreidimensional positionierbare Einrichtung (320) aufweist,
- eine Beladevorrichtung (50) zum sequenziellen Beladen der Fertigungsanlage (1) mit einer Mehrzahl von elektrischen Schaltungsträgern (s) und
- eine Speichervorrichtung (330) zum Bereitstellen (d0,d1,d2) einer Mehrzahl von Geometrie-Datensätzen (gᵢ) zu den einzelnen Schaltungsträgern (sᵢ),
∘ wobei die einzelnen Geometrie-Datensätze (gᵢ) jeweils eine Vielzahl von Ortsvektoren (x,y,z) aufweisen,
∘ wobei jeder Ortsvektor (x,y,z) ein laterales Koordinatenpaar (x,y) für die Position innerhalb der Schaltungsträgerebene und eine zugeordnete Höhenkoordinate (z) enthält,
wobei die ausgewählte Prozessvorrichtung (300) dazu ausgelegt ist, die einzelnen Schaltungsträger (sᵢ) sequenziell zu prozessieren,
- und dabei für den jeweils zu prozessierenden Schaltungsträger (sᵢ) den ihm zugeordneten Geometrie-Datensatz (gᵢ) zu verwenden,
um zu einer vorgegebenen lateralen Zielposition (x,y) der positionierbaren Einrichtung (320) eine zugehörige Ziel-Höhenkoordinate (z1) zu ermitteln
und die Einrichtung bei der lateralen Zielposition (x,y) in diese Ziel-Höhenkoordinate (z1) zu positionieren.
